# EUROPEAN PATENT SPECIFICATION

(11) **EP 2 467 873 B1**
(45) Date of publication and mention of the grant of the patent: **15.01.2014**
(21) Application number: 10720942.1
(22) Date of filing: 02.06.2010
(51) Int. Cl.: H01L 21/306, C09K 13/02, H01L 31/0236

(54) **METHOD FOR ETCHING OF SILICON SURFACES**
ÄTZVERFAHREN FÜR SILIKONFLÄCHEN
PROCÉDÉ DE GRAVURE DE SURFACES DE SILICIUM

(30) Priority: 20.08.2009 DE 102009028762
(43) Date of publication of application: 27.06.2012
(73) Proprietor: RENA GmbH, 78148 Gütenbach (DE)
(72) Inventor: EL JAOUHARI, Ahmed Abdelbar, 91077 Neunkirchen am Brand (DE); SCHWECKENDIEK, Jürgen, 10967 Berlin (DE)
(74) Representative: Gassner, Wolfgang
(86) International application number: PCT/EP2010/057737
(87) International publication number: WO 2011/020632

(56) References cited:
- EP-A1- 1 378 947
- WO-A1-2004/032218
- WO-A1-2008/052636
- JP-A- 2005 019 605

## Description

The invention relates to a method for etching of silicon surfaces, in particular wet-chemical, pyramidal texture etching of the surfaces of silicon wafers.

EP 0 944 114 B1 describes a method of wet-chemical, pyramidal texture etching of silicon surfaces for which an etching solution, among others Isopropanol and ethylene glycol, are added. The making of a pyramidal etching texture on silicon surfaces using the known etching solution requires a relatively long period of treatment of at least 25 to 30 minutes and a relatively high treatment temperature of 80°C to 85°C. Apart from that, the pyramidal etching textures made with the known etching solution do not have a particularly good homogeneity. The treated silicon surfaces differ particularly in the density, the size and the size distribution of the thus produced pyramids.

A further disadvantage of the known etching solution is that explosive mixtures of gases can be created by the evaporating Isopropanol and by the hydrogen released during the etching reaction. Due to this, it is necessary to continuously suction off the air above a treatment basin containing the etching solution.

A further disadvantage of the known etching solution is that the quality of the pyramidal etching texture is significantly reduced after having used the etching solution 8 to 10 times. To maintain a sufficient quality of the etching texture, it is necessary to renew the etching solution relatively frequently.

The document JP 2005 019605 A discloses a process for texturing silicon used in solar cells by using a solution heated at 60-90 °C of hydroxide (NaOH ot KOH) at a concentration of 0.5-12 % added with lignin or cellulose.

The object of the invention is to eliminate some of the disadvantages of the prior art. In particular, a method is to be specified with which homogeneous pyramidal etching textures can be made on silicon surfaces quickly and easily. In particular, the quality of the pyramidal etching texture and efficiency of the process is to be improved. According to a further goal of the invention, a new use is to be suggested.

This object is solved by the features of claims 1 and 12. Advantageous embodiments of the invention result from the features of claims 2 to 11 as well as 13.

According to the invention, a method for etching of silicon surfaces with the following steps is suggested:
Furnishing an aqueous alkaline hydrocolloid etching solution containing a combination of the hydrocolloids cellulose and pectin, at a temperature of 50°C to 95°C,
bringing the silicon surface in contact with the hydrocolloid etching solution for a specified duration, and
removing the hydrocolloid etching solution from the silicon surface.

Using the hydrocolloid etching solution as suggested in accordance with the invention, an addition of Isopropanol can be reduced or can be avoided. It surprisingly became apparent that the addition of a hydrocolloid shortens the duration of the etching process and pyramidal etching textures can be made in excellent homogeneous quality at the same time.

In the sense of the present invention, the term "hydrocolloids" is understood to mean a group of polysaccharides and proteins which dissolve in water as colloids and demonstrate a strong capacity for gelation. The term "a hydrocolloid" is understood to mean a hydrocolloid defined by a certain chemical composition.

The suggested method is particularly suitable for the making of pyramidal etching textures on silicon surfaces of silicon wafers. But aside from this, the method provided by the invention is also suitable for wet-chemical structure etching of optical or electro-chemical sensors, for catalyzers, for electrodes and similar.

The silicon surfaces to be treated have a (100) orientation. The etching pyramids made with the method provided by the invention have (111) surfaces. The duration of bringing the hydrocolloid etching solution into contact with the silicon surface affects the size of the created etching pyramids. The man skilled in the art will select a suitable duration depending on the sizes of the etching pyramids to be created.

According to an advantageous embodiment of the invention, the at least one hydrocolloid is contained in the hydrocolloid etching solution in a concentration of 0.01 to 2.0 g/l, preferably 0.01 to 0.99 g/l. The temperature of the hydrocolloid etching solution is advantageously set to 65°C to 90°C, preferably 68°C to 85°C. Further, it has proven to be advantageous to bring the silicon surface in contact with the hydrocolloid etching solution for a period of 5 to 25 minutes, preferably 10 to 20 minutes. Excellent results can already be achieved with a contact time of 10 minutes and a temperature ranging from 65°C to 70°C. The created pyramidal etching textures offer excellent homogeneity regarding density, size and size distribution of the etching pyramids.

According to a further advantageous embodiment, the hydrocolloid etching solution is made by adding at least one hydrocolloid to an aqueous etching solution. Thereby, the aqueous etching solution can be made by dissolving an alkali hydroxide in water. In particular, KOH or NaOH can be used as the alkali hydroxide. Mixtures of the previously mentioned alkali hydroxides can also be used.

It is advantageous that the alkali hydroxide is contained in the hydrocolloid etching solution in a concentration of 10 to 90 g/l, preferably 15 to 30 g/l.

It has proven to be particularly advantageous in making the hydrocolloid etching solution, to add the at least one hydrocolloid in aqueous solution to the etching solution. Thereby, the aqueous solution is advantageously alkaline.

The hydrocolloid etching solution can also contain Isopropanol. Surprisingly, it has turned out that an addition of a hydrocolloid to a conventional etching solution containing Isopropanol causes a considerable improvement of the etching texture. In particular, a conventional etching solution which must be considered exhausted can be refreshed by the addition of at least one hydrocolloid so that it can be used significantly longer. In other words, the number of substrates to be treated can be significantly increased, thus improving the efficiency of a conventional etching solution.

According to further provision of the invention, it is suggested that a hydrocolloid etching solution containing a combination of the hydrocolloids cellulose and pectin as well as KOH or NaOH in aqueous solution be used for a pretreatment of a basin to hold an etching solution for the etching of a silicon surface. The suggested pretreatment of the basin surprisingly causes a significant increase in efficiency of a conventional etching solution containing Isopropanol subsequently added.

A hydrocolloid etching solution used for the pretreatment of the basin contains the at least one hydrocolloid advantageously in a concentration of 0.01 to 2.0 g/l, preferably 0.01 to 0.99 g/l.

Naturally, it is also possible to use a mixture of several hydrocolloids to make the hydrocolloid etching solution.

Examples will now be used to describe the invention in more detail based on the drawings. The figures are listed below:
- Fig. 1: a first pyramidal etching texture on a silicon surface (50 x 50 µm) and
- Fig. 2: a second pyramidal etching texture on a silicon surface (50 x 50 µm).

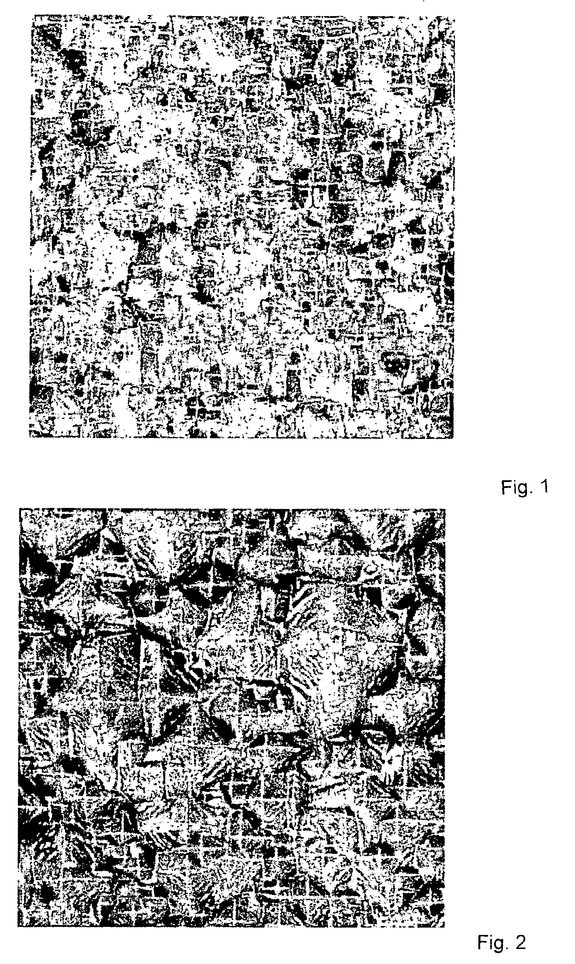

To make the pyramidal etching texture shown in Fig. 1, a hydrocolloid etching solution was used which was made from an aqueous etching solution and an aqueous alkaline solution containing the hydrocolloid. The aqueous etching solution was made by dissolving 1250 g KOH in 90 1 of water. The aqueous solution containing the hydrocolloid was made by dissolving carboxymethyl cellulose and pectin in 4 1 of water. Thereby, there was a weight ratio of carboxymethyl cellulose to pectin of approximately 8:1. Afterwards, the aqueous solution containing the hydrocolloids was mixed with the aqueous etching solution. Silicon wafers were dipped for a treatment period of 20 minutes in the thus prepared hydrocolloid etching solution at a temperature of 80°C. As is shown in Fig. 1, the surfaces made in this way have etching pyramids with a size in the range of approximately of 2 to 5 µm. A total of 10 µm was etched on every silicon surface of the silicon wafer.

With a further hydrocolloid etching solution, the aqueous etching solution was made by adding 3600 g KOH pellets to 90 1 of water. An aqueous solution containing the hydrocolloids, namely carboxymethyl cellulose and pectin, preferably in a ratio of 6:1, was added to the aqueous etching solution. The thus prepared hydrocolloid etching solution was heated to 75°C. During a 10-minute treatment, pyramidal etching textures can be made on silicon surfaces for which the etching pyramids have an average size of approximately 12 µm. Fig. 2 shows the pyramidal etching textures which were made on a silicon surface. - The section of the silicon surface shown in Fig. 1 and 2 is (50 x 50 µm) each in size.

To make an additive to refresh a conventional etching solution, for example containing Isopropanol, an aqueous solution is made which contains 0.3 to 0.9 g/l, preferably 0.5 to 0.7 g/l, of hydrocolloids. Thereby, for example, this is a mixture of carboxymethyl cellulose and pectin. A weight ratio of carboxymethyl cellulose : pectin can be 6:1 to approximately 8:1. The suggested additive is added to a conventional etching solution in such an amount that this contains approximately 10 to 30 mg, preferably 15 to 20 mg, of hydrocolloid. - Due to the action of the additive, the number of silicon wafers to be treated can be doubled in comparison with a conventional etching solution while retaining the same etching quality. It is possible to refresh the etching solution with the additive multiple times.

With the previously stated examples, the mixture ratio in the aqueous solution containing the hydrocolloids was advantageously carboxymethyl cellulose : pectin 6:1 to 8:1. The concentration of hydrocolloid in the hydrocolloid etching solution was advantageously 0.1 to 2.0 g/l.

Particularly a combination of the hydrocolloid pectin with cellulose, in particular carboxymethyl cellulose, is considered advantageous since this already can achieve an excellent efficiency and quality for pyramidal texture etching when a relatively low hydrocolloid total concentration in the hydrocolloid etching solution of a maximum of 2.0 g/l is used. The combination of the hydrocolloids cellulose/pectin can contain more than 50 percent in weight, preferably more than 60 percent in weight, particularly preferred more than 70 percent in weight of cellulose. The remainder consists of pectin.

## Claims

1. Method for etching of silicon surfaces with the following steps:
Furnishing an aqueous alkaline hydrocolloid etching solution containing a combination of the hydrocolloids cellulose and pectin, at a temperature of 50°C to 95°C,
bringing the silicon surface in contact with the hydrocolloid etching solution for a specified duration, and
removing the hydrocolloid etching solution from the silicon surface.

2. Method as defined in claim 1, wherein the at least one hydrocolloid is contained in the hydrocolloid etching solution in a concentration of 0.01 to 2.0 g/l, preferably 0.01 to 0.99 g/l.

3. Method as defined in one of the preceding claims, wherein the temperature of the hydrocolloid etching solution is set to 65°C to 90°C.

4. Method as defined in one of the preceding claims, wherein the silicon surface is brought in contact with the hydro-colloid etching solution for a period of 5 to 25 minutes, preferably 10 to 20 minutes.

5. Method as defined in one of the preceding claims, wherein the hydrocolloid etching solution is made by adding at least one hydrocolloid to an aqueous etching solution.

6. Method as defined in one of the preceding claims, wherein the aqueous etching solution is made by dissolving an alkali hydroxide in water.

7. Method as defined in one of the preceding claims, wherein KOH or NaOH is used as the alkali hydroxide.

8. Method as defined in one of the preceding claims, wherein the alkali hydroxide is contained in the hydrocolloid etching solution in a concentration of 10 to 90 g/l, preferably 15 to 30 g/l.

9. Method as defined in one of the preceding claims, wherein Isopropanol is contained in the hydrocolloid etching solution.

10. Method as defined in one of the preceding claims, wherein the at least one hydrocolloid being in aqueous solution is added to the etching solution to make the hydrocolloid etching solution.

11. Method as defined in one of the preceding claims, wherein the aqueous solution is alkaline.

12. Use of a hydrocolloid etching solution which contains in aqueous solution a combination of the hydrocolloids cellulose and pectin as well as KOH or NaOH, for a pretreatment of a basin to hold an etching solution for the etching of a silicon surface.

13. Use as defined in claim 12, wherein the at least one hydrocolloid is contained in the hydrocolloid etching solution in a concentration of 0.01 to 2.0 g/l, preferably 0.01 to 0.99 g/l.

## Patentansprüche

1. Verfahren zum Ätzen von Siliziumoberflächen mit den folgenden Schritten:
Bereitstellen einer wässrigen alkalischen Hydrokolloid-Ätzlösung, welche eine Kombination der Hydrokolloide Cellulose und Pektin enthält, bei einer Temperatur von 50°C bis 95°C,
Inkontaktbringen der Siliziumoberfläche mit der Hydrokolloid-Ätzlösung für eine vorgegebene Dauer, und
Entfernen der Hydrokolloid-Ätzlösung von der Siliziumoberfläche.

2. Verfahren nach Anspruch 1, wobei das zumindest eine Hydrokolloid in der Hydrokolloid-Ätzlösung in einer Konzentration von 0,01 bis 2,0 g/l, vorzugsweise 0,01 bis 0,99 g/l, enthalten ist.

3. Verfahren nach einem der vorhergehenden Ansprüche, wobei die Temperatur der Hydrokolloid-Ätzlösung auf 65°C bis 90°C eingestellt wird.

4. Verfahren nach einem der vorhergehenden Ansprüche, wobei die Siliziumoberfläche für eine Dauer von 5 bis 25 Minuten, vorzugsweise 10 bis 20 Minuten, mit der Hydrokolloid-Ätzlösung in Kontakt gebracht wird.

5. Verfahren nach einem der vorhergehenden Ansprüche, wobei die Hydrokolloid-Ätzlösung durch Zusatz zumindest eines Hydrokolloids zu einer wässrigen Ätzlösung hergestellt wird.

6. Verfahren nach einem der vorhergehenden Ansprüche, wobei die wässrige Ätzlösung durch Lösen eines Alkalihydroxids in Wasser hergestellt wird.

7. Verfahren nach einem der vorhergehenden Ansprüche, wobei als Alkalihydroxid KOH oder NaOH verwendet wird.

8. Verfahren nach einem der vorhergehenden Ansprüche, wobei das Alkalihydroxid in einer Konzentration von 10 bis 90 g/l, vorzugsweise 15 bis 30 g/l, in der Hydrokolloid-Ätzlösung enthalten ist.

9. Verfahren nach einem der vorhergehenden Ansprüche, wobei Isopropanol in der Hydrokolloid-Ätzlösung enthalten ist.

10. Verfahren nach einem der vorhergehenden Ansprüche, wobei zur Herstellung der Hydrokolloid-Ätzlösung das zumindest eine Hydrokolloid in wässriger Lösung der Ätzlösung zugesetzt wird.

11. Verfahren nach einem der vorhergehenden Ansprüche, wobei die wässrige Lösung alkalisch ist.

12. Verwendung einer Hydrokolloid-Ätzlösung, welche in wässriger Lösung eine Kombination der Hydrokolloide Cellulose und Pektin sowie KOH oder NaOH enthält, für eine Vorbehandlung eines Beckens, um eine Ätzlösung für das Ätzen einer Siliziumoberfläche aufzunehmen.

13. Verwendung nach Anspruch 12, wobei das zumindest eine Hydrokolloid in der Hydrokolloid-Ätzlösung in einer Konzentration von 0,01 bis 2,0 g/l, vorzugsweise 0,01 bis 0,99 g/l, enthalten ist.

## Revendications

1. Procédé de gravure de surfaces de silicium comprenant les étapes consistant à:
fournir une solution de gravure constituée d'une solution d'hydrocolloïde alcaline aqueuse contenant une combinaison de la cellulose d'hydrocolloïdes et de pectine, à une température de 50 °C à 95 °C,
amener la surface de silicium en contact avec la solution de gravure d'hydrocolloïde pendant une durée spécifiée, et
retirer la solution de gravure d'hydrocolloïde de la surface de silicium.

2. Procédé selon la revendication 1, selon lequel au moins l'un des hydrocolloïdes est contenu dans la solution de gravure d'hydrocolloïde dans une concentration comprise entre 0,01 et 2,0 g/l, de préférence entre 0,01 et 0,99 g/l.

3. Procédé selon l'une des revendications précédentes, selon lequel la température de la solution de gravure d'hydrocolloïde est réglée entre 65 °C et 90 °C.

4. Procédé selon l'une des revendications précédentes, selon lequel la surface de silicium est amenée en contact avec la solution de gravure d'hydrocolloïde pendant une durée comprise entre 5 et 25 minutes, de préférence entre 10 et 20 minutes.

5. Procédé selon l'une des revendications précédentes, selon lequel la solution de gravure d'hydrocolloïde est réalisée en ajoutant au moins un hydrocolloïde à une solution de gravure aqueuse.

6. Procédé selon l'une des revendications précédentes, selon lequel la solution de gravure aqueuse est réalisée par dissolution d'un hydroxyde alcalin dans de l'eau.

7. Procédé selon l'une des revendications précédentes, selon lequel du KOH ou du NaOH est utilisé comme hydroxyde alcalin.

8. Procédé selon l'une des revendications précédentes, selon lequel l'hydroxyde alcalin est contenu dans la solution de gravure d'hydrocolloïde dans une concentration comprise entre 10 et 90 g/l, de préférence entre 15 et 30 g/l.

9. Procédé selon l'une des revendications précédentes, selon lequel de l'isopropanol est contenu dans la solution de gravure d'hydrocolloïde.

10. Procédé selon l'une des revendications précédentes, selon lequel au moins l'un des hydrocolloïdes qui est dans une solution aqueuse est ajouté à la solution de gravure pour réaliser la solution de gravure d'hydrocolloïde.

11. Procédé selon l'une des revendications précédentes, selon lequel la solution aqueuse est alcaline.

12. Utilisation d'une solution de gravure d'hydrocolloïde qui contient dans une solution aqueuse une combinaison de la cellulose d'hydrocolloïdes et de pectine ainsi que du KOH ou NaOH, pour un prétraitement d'un bassin pour contenir une solution de gravure pour la gravure d'une surface de silicium.

13. Utilisation selon la revendication 12, selon laquelle au moins l'un des hydrocolloïdes est contenu dans la solution de gravure d'hydrocolloïde dans une concentration comprise entre 0,01 et 2,0 g/l, de préférence entre 0,01 et 0,99 g/l.
